# EUROPEAN PATENT SPECIFICATION

(11) **EP 0 441 009 B1**
(45) Date of publication and mention of the grant of the patent: **14.09.1994**
(21) Application number: 90250258.2
(22) Date of filing: 08.10.1990
(51) Int. Cl.: H02H 5/08, H05K 7/00

(54) **Electric circuit unit and manufacturing method thereof**
Elektrische Schaltung und deren Herstellungsverfahren
Circuit électrique et sa méthode de fabrication

(30) Priority: 29.01.1990 JP 18188/90
(43) Date of publication of application: 14.08.1991
(73) Proprietor: Uchiya Thermostat Co., Misato-shi Saitama-ken (JP)
(72) Inventor: Takeda, Hideaki, Misato-shi, Saitama-ken (JP)
(74) Representative: Meissner, Peter E., Dipl.-Ing.

(56) References cited:
- EP-A- 0 416 716
- GB-A- 813 426
- US-A- 4 568 795
- US-A- 4 799 124

## Description

### FIELD OF THE INVENTION AND RELATED ART STATEMENT

The present invention relates to an electric circuit unit which is flexible and water-proof and to a manufacturing method thereof.

An electric appliance such as a hair dryer is known which incorporates an electric circuit unit such as a power interrupter circuit or the like which interrupts the power source immediately when the electric appliance is dropped into water in order to avoid an electric shock.

A water sensitive power interrupter circuit which detects water entering the circuit to interrupt a power source is disclosed in, for example, Japanese Patent Unexamined Publication No. 1-298817 and in European Patent Application 90 250 208.7 (EP-A-0416716) which is a document falling under the terms of Article 54(3) EPC.

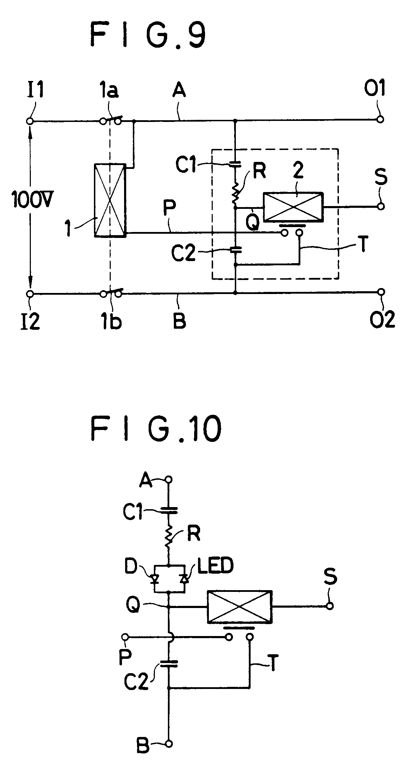

Fig. 9 is a circuit diagram of an example of such a power interrupter circuit.

A power source (not shown) connected to input terminals I1 and I2 is connected to a load connected to output terminals O1 and O2 through contacts 1a and 1b of a solenoid relay 1. A coil of the solenoid relay 1 is connected in series to a contact of a reed relay 2 and connected through the contacts 1a and 1b to the power source. A voltage of the power source is divided by a voltage divider composed of a first capacitor C1, a resistor R and a second capacitor C2 and a divided voltage is applied to one terminal of the reed relay 2. The other terminal of the reed relay 2 constitutes a water detecting sensor. When the water detecting sensor and the load are dropped into the water, a weak current flows through the water and consequently the contact of the reed relay 2 is closed, so that the voltage of the power source is directly applied to the coil of the solenoid relay 1 and the contacts of the solenoid relay 1 are opened to interrupt the connection between the power source and the load.

Fig. 10 is a modification of the circuit of Fig. 9. A series circuit including first and second capacitors C1 and C2 and a resistor R contains a light emitting diode LED and a diode D. The light emitting diode emits light when a voltage of a power source is applied to the series circuit. Other modifications of the power interrupter circuit are disclosed in the above-mentioned applications.

Such power interrupter circuits can detect a weak current flowing through the water to control a large current. Further, since it does not require an amplifier and can be made small, it can be incorporated into a hair dryer or the like.

### OBJECT AND SUMMARY OF THE INVENTION

Generally, such an electric circuit unit can be realized by mounting circuit elements on a printed circuit board and covering them by water-proof material.

However, the electric appliance to be equipped with the electric circuit unit can take various shapes depending on the design thereof and the shape of a space in which the electric circuit unit is mounted can also be varied. Accordingly, even if the function of the electric circuit unit is the same, it is necessary to provide the electric circuit unit using a different printed circuit board for each model of the electric appliance.

It is an object of the present invention to provide an electric circuit unit which can be applied to electric appliances having various shapes and can be easily mounted in a space even if the space is bent, for example, as in a corner of the electric appliance, and a manufacturing method thereof.

The above problem is solved by an electric circuit unit including a plurality of electric circuit elements in which connection between terminals of the electric circuit elements is made directly or using flexible conductors and the whole of the electric circuit unit is covered by a deformable and contractile tube with entrance and exit of conductors for connecting the electric circuit unit to an external electric circuit being sealed by waterproof synthetic resin in a watertight manner so that at least a portion of the unit can be bent.

The electric circuit elements are connected with each other directly or using flexible conductors without using a printed circuit board. Accordingly, the whole of the electric circuit unit can be bent by deforming the terminals of the electric circuit elements or the conductors slightly. Thus, if the shape of a space in which the electric circuit unit is mounted is, for example, of L-shape, the electric circuit unit can be inserted into the narrow L-shaped space by bending the electric circuit unit into a L-shape when the electric circuit unit is mounted.

Further, since the electric circuit unit is covered by a thermal contractile tube and a waterproof synthetic resin, the electric circuit operates exactly even if the electric appliance is dropped into water. Manufacturing methods according to the invention are specified in claims 3, 4 and 5.

### BRIEF DESCRIPTION OF THE DRAWINGS

Fig. 1 is a perspective view of an embodiment of an electric circuit unit according to the present invention;
Fig. 2 is a perspective view of the electric circuit unit of Fig. 1 which is bent;
Fig. 3 is a perspective view of another embodiment of an electric circuit unit according to the present invention;
Fig. 4 is a perspective view of the electric circuit unit of Fig. 3 which is bent;
Fig. 5 is a front view of a further embodiment of an electric circuit unit according to the present invention;
Fig. 6 is a plan view of the electric circuit unit of Fig. 5;
Fig. 7 is a plan view of an electric circuit unit according to the present invention;
Fig. 8 is a plan view of the electric circuit unit of Fig. 3;
Fig. 9 is a circuit diagram of an example of a water detection type power interrupter circuit; and
Fig. 10 is a circuit diagram of a modification of a portion enclosed by broken line of Fig. 9.

### DETAILED DESCRIPTION OF PREFERRED EMBODIMENTS

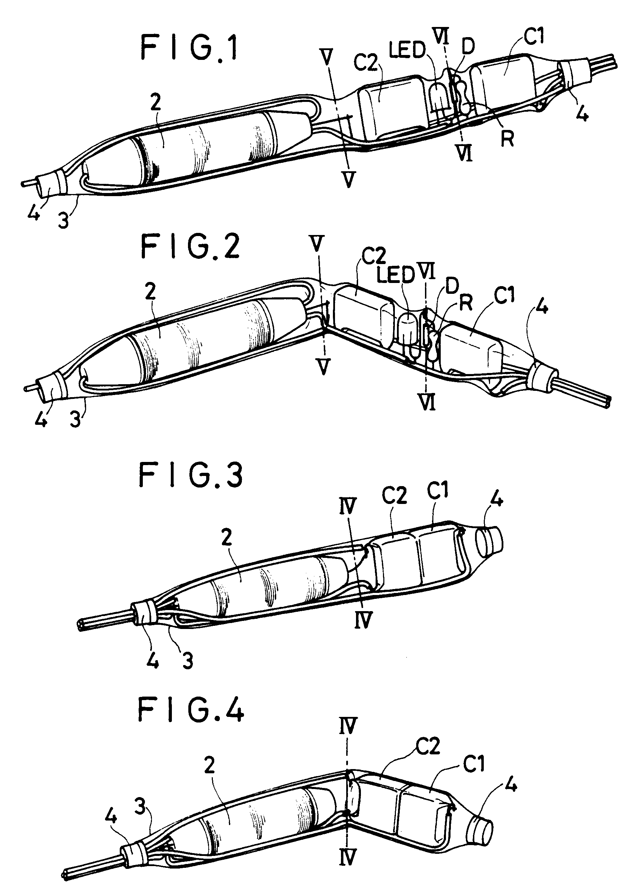

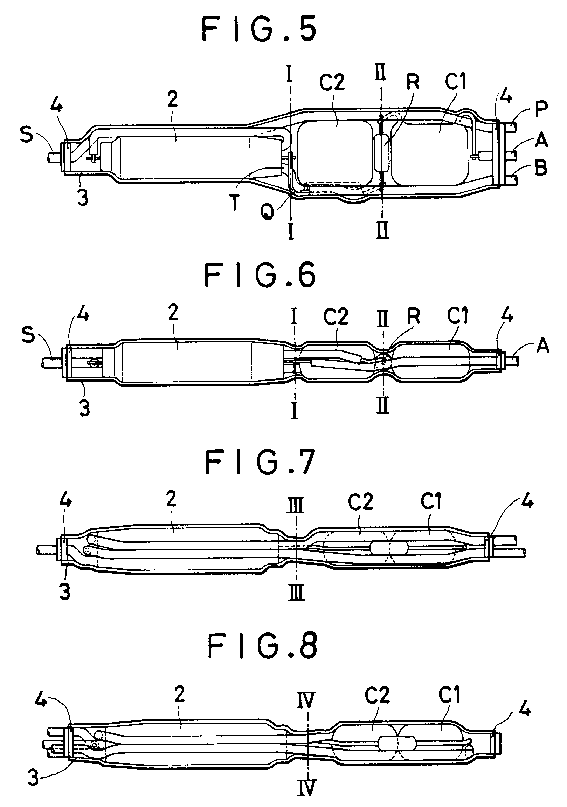

Fig. 1 is a perspective view of an electric circuit unit according to the present invention corresponding to the electric circuit of Fig. 10. This circuit includes a parallel connection of a light emitting diode LED and a diode D which is connected in series to a resistor R of the electric circuit unit of Figs. 5 and 6 described later. Since only lead wires are disposed in an intermediate portion V between a reed relay 2 and a second capacitor C2 of the electric circuit unit, the intermediate portion V can be bent, while since only small electric elements such as a resistor R, a light emitting diode LED and a diode D are disposed in an intermediate portion VI the the second capacitor C2 and a first capacitor C1, the intermediate portion VI can be also bent similarly. Fig. 2 is a perspective view of the electric circuit unit of Fig. 1 which is bent at the portion V.

Fig. 3 is a perspective view of an electric circuit unit of Fig. 8, and Fig. 4 is a perspective view of the electric circuit of Fig. 8 which is bent at a portion IV. In this manner, the electric circuit unit can be bent so that the unit can be inserted into an electric appliance easily even if a space in the electric appliance is L-shaped or bent.

Fig. 5 is a front view of an electric circuit unit according to the present invention corresponding to the circuit enclosed by broken line of Fig. 9, and Fig. 6 is a plan view of the electric circuit unit of Fig. 5.

The electric circuit unit includes a reed relay 2, first and second capacitors C1 and C2, and a resistor R. A lead wire A is connected to one terminal of the first capacitor C1 and the other terminal of the first capacitor C1 is connected to one terminal of the resistor R with the other terminal of the resistor R being directly connected to one terminal of the second capacitor C2 which has the other terminal to which a lead wire B is connected. A lead wire Q branched from a junction of the second capacitor C2 and the resistor R is connected to one terminal of the reed relay 2 and a lead wire S is connected to the other terminal of the reed relay 2. One terminal of the reed relay 2 is connected through a lead wire T to the second capacitor C2 so that the one terminal of the reed relay 2 is connected to the lead wire B and the other terminal thereof is connected to a lead wire P.

The whole of the electric circuit thus connected is covered by a thermal contractile tube 3, and entrance and exit portions of the lead wires A, B, P and S are sealed by waterproof synthetic resin 4 in a watertight manner.

As apparent from Figs. 5 and 6, since there is not a large electric element in an intermediate portion I between the reed relay 2 and the second capacitor C2, the electric circuit unit can be bent at the intermediate portion I. Further, the electric circuit unit can be also bent at an intermediate portion II between the second capacitor C2 and the first capacitor C1 while the resistor R acts as an axis.

Figs. 7 and 8 are front views of further embodiments of the electric circuit units according to the present invention.

These electric circuit units correspond to the electric circuit in the broken line of Fig. 9.

In the electric circuit unit of Fig. 7, the resistor R disposed between the two capacitors C1 and C2 in Figs. 5 and 6 is disposed under both of the capacitors C1 and C2. In the electric circuit unit of Fig. 8, the lead wires A, B, P and S in the electric circuit unit of Fig. 7 are disposed to one side.

The electric circuit units in the embodiments of Figs. 7 and 8 can be bent at intermediate portions III and IV between the reed relay 2 and the second capacitor C2.

Polyolefin, vinyl chloride or polyvinylidene fluoride, for example, can be used as material for the thermal contractile tube for covering the electric circuit unit according to the present invention and is commercially available as a thermal contractile tube.

Waterproof synthetic resin can use commercially available adhesive agent such as polyamide, ethylene vinyl acetate, polypropylene or the like which is melted by heating.

The effects of the present invention are as follows:
i) It is not necessary to provide a printed circuit board in accordance with a shape of the electric appliance.
ii) Since a printed circuit board is not used, the electric circuit unit can be formed to be very compact.
iii) Since the electric circuit unit is deformable, the unit can be easily inserted into a narrow space.

## Claims

1. An electric circuit unit including a plurality of electric circuit elements (2, R, C1, C2), characterized in that connection between terminals of said electric circuit elements is made directly or using flexible conductors (Q, T), the whole of said electric circuit unit is covered by a deformable and contractile tube (4), and entrance and exit of conductors (A, B, P, S) for connecting said electric circuit unit to an external electric circuit being sealed by waterproof synthetic resin (4) in a watertight manner, so that at least a portion of said electric circuit unit can be bent.

2. An electric circuit unit according to Claim (1), wherein said electric circuit elements include a reed relay (2), two capacitors (C1, C2) and a resistor (R).

3. A method of manufacturing an electric circuit unit including a plurality of electric circuit elements (2, R, C1, C2), characterized in that connection between terminals of said electric circuit elements is made directly or using flexible conductors (Q, T) so that said electric circuit unit can be bent in at least one portion, the whole of said electric circuit unit is covered by a deformable and contractile tube (3), and entrance and exit of conductors (A, B, P, S) for connecting said electric circuit unit to an external electric circuit is filled with waterproof synthetic resin (4) made of a thermally meltable adhesive agent and is sealed in watertight manner by heating said resin.

4. A method of manufacturing an electric circuit unit comprising a reed relay (2), first (C1) and second (C2) capacitors and a resistor (R), characterized in that said reed relay, first and second capacitors and resistor are disposed substantially straight, one terminal of the first capacitor (C1) is directly connected to one terminal of the resistor (R), the other terminal of the resistor (R) is connected to one terminal of the second capacitor (C2) directly and through a flexible lead wire (Q) to one terminal of the reed relay (2), the other terminal of the second capacitor (C2) is directly connected to one contact of the reed relay (2), the other terminal of the first capacitor (C1), the other terminal of the second capacitor (C2), the other terminal of the reed relay (2) and the other contact of the reed relay (2) are connected to flexible lead wires (A, B, S, P) for connection to an external circuit, the whole of said electric circuit unit is covered by a deformable and contractile tube (3), and entrance and exit of the conductors (A, B, S, P) is filled with waterproof synthetic resin (4) made of a thermally meltable adhesive agent and is sealed in watertight manner by heating said resin.

5. A method of manufacturing an electric circuit unit comprising a reed relay (2), a resistor (R), first (C1) and second (C2) capacitors, a hight emitting diode (LED) and a diode (D), characterized in that said reed relay, first and second capacitors, resistor, light emitting diode and diode are disposed substantially straight, one terminal of the first capacitor (C1) is directly connected to one terminal of the resistor (R), the other terminal of the resistor (R) is directly connected to one terminal of a reverse parallel circuit of the light emitting diode (LED) and the diode (D), the other terminal of the reverse parallel circuit is connected to one terminal of the second capacitor (C2) directly and through a flexible lead wire (Q) to one terminal of the reed relay, the other terminal of the second capacitor (C2) is directly connected to one contact of the reed relay, the other terminal of the first capacitor (C1), the other terminal of the second capacitor (C2), the other terminal of the reed relay and the other contact of the reed relay are connected to flexible lead wires (A, B, S, P) for connection to an external circuit, the whole of said electric circuit unit is covered by a deformable and contractile tube (3), and entrance and exit of the conductors (A, B, S, P) is filled with waterproof synthetic resin (4) made of a thermally meltable adhesive agent and is sealed in watertight manner by heating said resin.

## Patentansprüche

1. Elektrische Schaltungseinheit mit einer Mehrzahl elektrischer Schaltelemente (2, R, C1, C2), dadurch gekennzeichnet, dass die Verbindung zwischen Anschlüssen der elektrischen Schaltelemente direkt oder mittels flexibler Leiter (Q, T) ausgeführt ist, die ganze elektrische Schaltungseinheit durch einen deformierbaren und kontrahierbaren Schlauch (4) umhüllt ist, und der Ein- und Austritt von Leitern (A, B, P, S) zur Verbindung der elektrischen Schaltungseinheit mit einer externen elektrischen Schaltung in wasserdichter Weise mittels synthetischem Harz (4) abgedichtet ist, so dass mindestens ein Teil der elektrischen Schaltungseinheit verbogen werden kann.

2. Elektrische Schaltungseinheit nach Anspruch 1, wobei die elektrischen Schaltelemente ein Reed-Relais (2), zwei Kondensatoren (C1, C2) und einen Widerstand (R) umfassen.

3. Verfahren zur Herstellung einer elektrischen Schaltungseinheit mit einer Mehrzahl elektrischer Schaltelemente (2, R, C1, C2), dadurch gekennzeichnet, dass die Verbindung zwischen Anschlüssen der elektrischen Schaltelemente direkt oder mittels flexibler Leiter (Q, T) ausgeführt ist, so dass die elektrische Schaltungseinheit in mindestens einem Teil verbogen werden kann, die ganze elektronische Schaltungseinheit mit einem deformierbaren und kontrahierbaren Schlauch (3) eingehüllt wird, und Ein- und Austritt von Leitern (A, B, P, S) zur Verbindung der elektrischen Schaltungseinheit mit einer externen elektrischen Schaltung mit wasserfestem synthetischem Harz (4) aus einem thermisch schmelzbaren, adhäsiven Mittel gefüllt wird und in wasserdichter Weise mittels Erwärmung des Harzes abgedichtet wird.

4. Verfahren zur Herstellung einer elektrischen Schaltungseinheit, die ein Reed-Relais (2), erste (C1) und zweite (C2) Kondensatoren und einen Widerstand (R) umfasst, dadurch gekennzeichnet, dass das Reed-Relais, der erste und zweite Kondensator und der Widerstand im wesentlichen gerade angeordnet werden, ein Anschluss des ersten Kondensators (C1) direkt mit einem Anschluss des Widerstands (R) verbunden wird, der andere Anschluss des Widerstands (R) direkt mit einem Anschluss des zweiten Kondensators (C2) und über ein flexibles Kabel (Q) mit einem Anschluss des Reed-Relais (2) verbunden wird, der andere Anschluss des zweiten Kondensators (C2) direkt mit einem Kontakt des Reed-Relais (2) verbunden wird, der andere Anschluss des ersten Kondensators (C1), der andere Anschluss des zweiten Kondensators (C2), der andere Anschluss des Reed-Relais (2) und der andere Kontakt des Reed-Relais (2) zum Anschluss an eine externe Schaltung mit flexiblen Verbindungskabeln (A, B, S, P) verbunden werden, die ganze elektrische Schaltungseinheit mit einem deformierbaren und kontrahierbaren Schlauch (3) eingehüllt wird, und Ein- und Austritt der Leiter (A, B, S, P) mit wasserfestem synthetischem Harz (4) aus einem thermisch schmelzbaren, adhäsiven Mittel gefüllt wird und in wasserdichter Weise mittels Erwärmung des Harzes abgedichtet wird.

5. Verfahren zur Herstellung einer elektrischen Schaltungseinheit, die ein Reed-Relais (2), einen Widerstand (R), erste (C1) und zweite (C2) Kondensatoren, eine Leuchtdiode (LED) und eine Diode (D) umfasst, dadurch gekennzeichnet, dass das Reed-Relais, der erste und zweite Kondensator, der Widerstand, die Leuchtdiode und die Diode im wesentlichen gerade angeordnet werden, ein Anschluss des ersten Kondenstors (C1) direkt mit einem Anschluss des Widerstands (R) verbunden wird, der andere Anschluss des Widerstands (R) direkt mit einem Anschluss einer umgekehrt parallelen Schaltung aus der Leuchtdiode (LED) und der Diode (D) verbunden wird, der andere Anschluss der umgekehrt parallelen Schaltung direkt mit einem Anschluss des zweiten Kondensators (C2) und durch ein flexibles Verbindungskabel (Q) mit einem Anschluss des Reed-Relais verbunden wird, der andere Anschluss des zweiten Kondensators (C2) direkt mit einem Kontakt des Reed-Relais verbunden wird, der andere Anschluss des ersten Kondensators (C1), der andere Anschluss des zweiten Kondesators (C2), der andere Anschluss des Reed-Relais und der andere Kontakt des Reed-Relais mit flexiblen Verbindungsleitungen (A, B, S, P) zum Anschluss an eine externe Schaltung verbunden werden, die ganze elektronische Schaltungseinheit mit einem deformierbaren und kontrahierbaren Schlauch (3) eingehüllt wird, und Ein- und Austritt der Leiter (A, B, S, P) mit wasserfestem synthetischem Harz (4) aus einem thermisch schmelzbaren, adhäsiven Mittel gefüllt wird und in wasserdichter Weise mittels Erwärmung des Harzes abgedichtet wird.

## Revendications

1. Unité de circuit électrique, incluant une pluralité d'éléments de circuit électrique (2,R,C1,C2),
caractérisée en ce que la connexion entre les bornes desdits éléments de circuit électrique est réalisée directement ou en utilisant des conducteurs souples (Q,T), l'ensemble de ladite unité de circuit électrique étant recouvert par un tube contractile et déformable (3), et l'entrée et la sortie des conducteurs (A,B,P,S) pour relier ladite unité de circuit électrique à un circuit électrique externe étant fermées par une résine synthétique (4) de façon étanche à l'eau, de sorte qu'au moins une portion de ladite unité de circuit électrique peut être courbée.

2. Unité de circuit électrique selon la revendication 1, dans laquelle lesdits éléments de circuit électrique incluent un relais Reed (2), deux condensateurs (C1,C2), et une résistance (R).

3. Procédé pour fabriquer une unité de circuit électrique incluant une pluralité d'éléments de circuit électrique (2,R,C1,C2),
caractérisé en ce que la connexion entre les bornes desdits éléments de circuit électrique est réalisée directement en utilisant des conducteurs souples (Q,T), de sorte que ladite unité de circuit électrique peut être courbée dans au moins une portion, l'ensemble de ladite unité de circuit électrique étant recouvert par un tube contractile et déformable (3), et l'entrée et la sortie des conducteurs (A,B,P,S) pour relier ladite unité de circuit électrique à un circuit électrique externe sont remplies d'une résine synthétique étanche à l'eau (4) réalisée en un agent adhésif pouvant être thermiquement fondu et sont fermées de façon étanche à l'eau en chauffant ladite résine.

4. Procédé pour fabriquer une unité de circuit électrique comprenant un relais Reed (2), des premier (C1) et second (C2) condensateurs et une résistance (R),
caractérisé en ce que ledit relais Reed, lesdits premier et second condensateurs et la résistance sont disposés sensiblement de façon rectiligne, une borne du premier condensateur (C1) est reliée directement à une borne de la résistance (R), l'autre borne de la résistance (R) est reliée à une borne du second condensateur (C2) directement et par l'intermédiaire d'un fil conducteur souple (Q) à une borne du relais Reed (2), l'autre borne du second condensateur (C2) est directement reliée à un contact du relais Reed (2), l'autre borne du premier condensateur (C1), l'autre borne du second condensateur (C2), l'autre borne du relais Reed (2), et l'autre contact du relais Reed (2) sont reliés à des fils conducteurs souples (A,B,S,P) pour la connexion à un circuit externe, l'ensemble de ladite unité de circuit électrique est recouvert par un tube contractile et déformable (3), et l'entrée et la sortie des conducteurs (A,B,S,P) sont remplies d'une résine synthétique étanche à l'eau (4) réalisée en un agent adhésif pouvant être thermiquement fondu et sont fermées de façon étanche à l'eau en chauffant ladite résine.

5. Procédé pour fabriquer une unité de circuit électrique comprenant un relais Reed (2), une résistance (R), des premier (C1) et second (C2) condensateurs, une diode électroluminescente (LED) et une diode (D),
caractérisé en ce que ledit relais Reed, les premier et second condensateurs, la résistance, la diode électroluminescente et la diode sont disposés sensiblement de façon rectiligne, une borne du premier condensateur (C1) est reliée directement à une borne de la résistance (R), l'autre borne de la résistance (R) est directement reliée à une borne d'un circuit parallèle inverse de la diode électroluminescente (LED) et de la diode (D), l'autre borne du circuit parallèle inverse est reliée à une borne du second condensateur (C2) directement et par l'intermédiaire d'un fil conducteur souple (Q) à une borne du relais Reed, l'autre borne du second condensateur (C2) est directement reliée à un contact du relais Reed, l'autre borne du premier condensateur (C1), l'autre borne du second condensateur (C2), l'autre borne du relais Reed et l'autre contact du relais Reed sont reliés à des fils conducteurs souples (A,B,S,P) pour la connexion à un circuit externe, l'ensemble de ladite unité de circuit électrique étant recouvert par un tube contractile et déformable (3), et l'entrée et la sortie des conducteurs (A,B,S,P) sont remplies d'une résine synthétique étanche à l'eau (4) réalisée en un agent adhésif pouvant être thermiquement fondu et sont fermées de façon étanche à l'eau en chauffant ladite résine.
